# EUROPEAN PATENT SPECIFICATION

(11) **EP 1 912 332 B1**
(45) Date of publication and mention of the grant of the patent: **18.04.2012**
(21) Application number: 07114023.0
(22) Date of filing: 08.08.2007
(51) Int. Cl.: H03K 19/0944, G09G 3/32

(54) **Logic gate, scan driver and organic light emitting diode display using the same**
Logik-Gate, Zeilentreiber und organische lichtemittierende Diodenanzeige damit
Porte logique utilisée dans une commande de balayage pour affichage à diodes électroluminescentes organiques

(30) Priority: 08.08.2006 KR 20060074586
(43) Date of publication of application: 16.04.2008
(73) Proprietor: Samsung Mobile Display Co., Ltd., Suwon-si Gyeonggi-do (KR)
(72) Inventor: Chung, Bo-yong Legal & IP Team, Samsung SDI Co., LTD., Gyeonggi-do (KR); Lee, Wang-jo, Legal & IP Team, Samsung SDI Co., LTD., Gyeonggi-do (KR); Kim, Hyung-soo, Legal & IP Team, Samsung SDI Co., LTD., Gyeonggi-do (KR); Choi, Sang-moo, Legal & IP Team, Samsung SDI Co., LTD., Gyeonggi-dong (KR)
(74) Representative: Ziebig, Marlene

(56) References cited:
- US-A- 5 694 061

## Description

### BACKGROUND

### 1. Field of the Invention

The present invention relates to a logic gate capable of being realized using MOS transistors of a single type only and a scan driver and an organic light emitting display using the logic gate, and more specifically to a logic gate capable of being realized with PMOS transistors and a scan driver and an organic light emitting display using the logic gate.

### 2. Discussion of Related Art

In recent years, various types of flat panel displays having reduced weight and volume which are disadvantages of cathode ray tubes (CRTs) have been developed. The types of flat panel displays include liquid crystal displays (LCDs), field emission displays (FEDs), plasma display panels (PDPs), organic light emitting diode displays (OLEDs), etc.

The OLED displays an image using organic light emitting diodes which generate light by means of recombination of electrons and holes. Such an organic light emitting display device has an advantage in that it has a rapid response time and consumes low power.

Generally, an OLED display includes pixels arranged in a matrix-type manner, a data driver for driving data lines connected to the pixels, and a scan driver for driving scan lines connected to the pixels.

The data driver supplies a data signal to the pixels selected by a scan signal provided by the scan driver. Therefore, each of the pixels displays a predetermined image corresponding to the data signal by supplying a predetermined electric current, corresponding to the data signal, to an organic light emitting diode.

It is desirable to mount the scan driver on the panel to reduce the manufacturing cost of the OLED. However, it is difficult to do so since the conventional scan driver is composed of PMOS transistors and NMOS transistors. That is to say, the problem is that the number of masks and thus of the production steps required will increase when the scan driver composed of PMOS and NMOS transistors is formed on the panel. Accordingly, there has been demand for a scan driver capable of being realized with MOS transistors of a single polarity type only in order to be able to form it on a panel.

US 5694061 discloses a semiconductor device having at least first and second MIS transistors of a same P or N conductive type. The first MIS transistor has a first data terminal which receives a high potential Vdd, and the second MIS transistor has a first data terminal which receives a low potential GND lower than the high potential Vdd. An output terminal is coupled to second data terminals of the first and second MIS transistors. A first input terminal is connected to a gate of the first MIS transistor for supplying a non-inverted signal. A second input terminal is directly connected to a gate of one of the first and second MIS transistors for supplying an inverted signal having a reverse polarity to the non-inverted signal and which is synchronized with the non-inverted signal. An output voltage compensating circuit is connected between one of (i) the output terminal and the first input terminal and (ii) the output terminal and the second input terminal. The output voltage compensating circuit prevents the lower potential of an output signal from rising if the semiconductor device includes PMIS transistors, and prevents the higher potential of the output signal from falling if the semiconductor device includes NMIS transistors.

### SUMMARY OF THE INVENTION

Accordingly, the present invention is designed to solve such drawbacks of the prior art, and therefore an object of the present invention is to provide a logic gate capable of being realized with MOS transistors of a single polarity type, a scan driver and an organic light emitting display using the same.

Accordingly, a first aspect of the present invention provides an OR gate comprising a first power source, a second power source, a plurality of input terminals, a first driver, a second driver, a third driver, a control transistors, a first capacitor, and a fourth driver. The first power source is adapted to provide a first power supply voltage and the second power source is adapted to provide a second power supply voltage, different from the first power supply voltage. The plurality of input terminals is adapted to receive a plurality of input signals. The first driver has a first terminal connected to the first power source, a second terminal connected to a first node, and a plurality of inputs, each of the plurality of inputs being connected to a corresponding one of the plurality of input terminals. The second driver has a first terminal connected to the first node, and a second terminal connected to the second power source. The third driver has a first terminal connected to the first power source, an input connected to the first node, and an output terminal. The control transistor has a first electrode connected to the output terminal of the third driver, a second electrode connected to the second power source, and a gate electrode. The fourth driver has a first terminal connected to the gate electrode of the control transistor and a second terminal connected to the second power source. The first capacitor has a first terminal connected to the first electrode of the control transistor and a second terminal connected to the gate electrode of the control transistor.

The first driver is adapted to provide the first power supply voltage to the first node corresponding to a logic combination of the plurality of input signals and the second driver is adapted to provide the second power supply voltage to the first node when the first driver does not provide the first power supply voltage to the first node. The third driver is adapted to provide the first power supply voltage to the output terminal when the second power supply voltage is provided to the first node and the fourth driver is adapted to provide the second power supply voltage to the gate electrode of the control transistor when the third driver does not provide the first power supply voltage to the output terminal. Each of the first driver, the second driver, the third driver, and the fourth driver comprises at least one transistor. These transistors and the control transistor are MOS transistors of the same polarity type.

The OR-gate of the first aspect of the invention has an advantage in that in comprises transistors only of a single polarity type, preferably PMOS transistors, and therefore can be integrated into the display panel of an OLED display device without increasing the number of production steps and therefore production cost.

A second aspect of the invention provides a scan driver scan driver comprising at least one decoder having a plurality of first OR gates according to first aspect of the invention and a plurality of second OR gates, also according to the first aspect of the invention. Each of the plurality of input terminals of any of the plurality of second OR gates is connected to an output terminal of one of the plurality of first OR gates of any one of the at least one decoders. The scan driver of the second aspect of the invention has an advantage in that it can be integrated into the display panel of an OLED display device without increasing the number of production steps and therefore production cost.

A third aspect of the invention provides an OLED display device comprising a scan driver according to the second aspect of the invention.

### BRIEF DESCRIPTION OF THE DRAWINGS

These and/or other aspects and advantages of the invention will become apparent and more readily appreciated from the following description of the preferred embodiments, taken in conjunction with the accompanying drawings of which:

FIG. 1 illustrates a circuit view of an OR gate according to the first embodiment of the present invention,

FIG. 2 illustrates a circuit view of an OR gate according to the second embodiment of the present invention,

FIG. 3 illustrates a circuit view of an OR gate according to the third embodiment of the present invention,

FIG. 4 illustrates a circuit view of an OR gate according to the fourth embodiment of the present invention,

FIG. 5 illustrates a circuit view of an OR gate according to the fifth embodiment of the present invention,

FIG. 6 illustrates a circuit view of a scan driver according to one embodiment of the present invention,

FIG 7 illustrates driving waveforms according to an embodiment of the present invention,

FIG. 8 illustrates a circuit view of an example of a connection procedure of the first OR gates as shown in FIG. 6,

FIG 9A illustrates a detailed view of driving waveforms according to an embodiment of the present invention,

FIG 9B illustrates driving waveforms according to another embodiment of the present invention,

FIG 10 illustrates a schematic view of an organic light emitting diode display according to an embodiment of the present invention.

### DETAILED DESCRIPTION OF THE INVENTION

Hereinafter, preferable embodiments of the present invention will be described with reference to the accompanying drawings, as apparent to those skilled in the art. Here, when one element is described as being connected to a second element, the element may be directly connected to the second element but also indirectly via another, third, element. Further, irrelative elements may be omitted for clarity. Like reference numerals refer to like elements throughout.

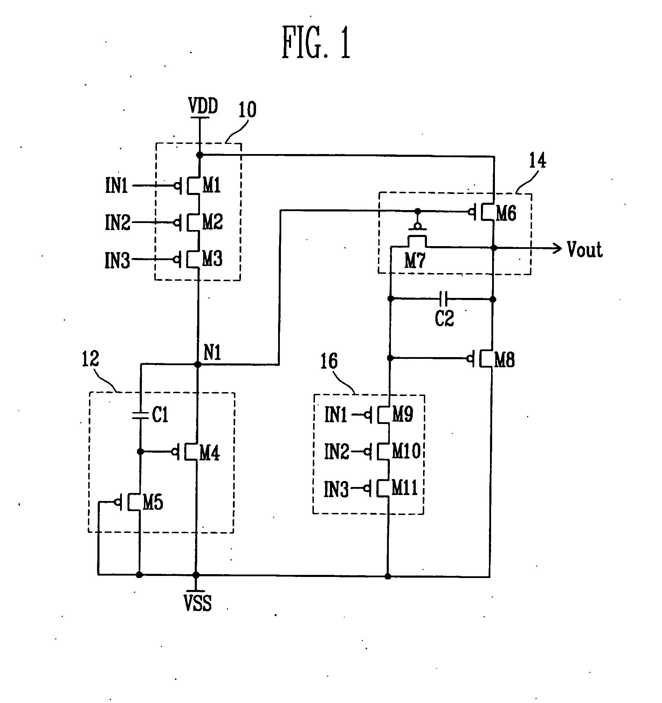

FIG. 1 is a circuit view showing an OR gate according to the first embodiment of the present invention. Here, the OR gate according to the first embodiment of the present invention is realized with PMOS transistors.

Referring to FIG 1, the OR gate according to the first embodiment of the present invention comprises an eighth transistor (M8) (a control transistor) for controlling the voltage supplied to an output terminal (Vout); a first driver 10 arranged between a first power source (VDD) and a first node (N1) and controlling the connection of the first node (N1) to the first power source (VDD) to correspond to polarities (HIGH or LOW) of a first input signal (IN1), a second input signal (IN2) and a third input signal (IN3); a second driver 12 arranged between the first node (N1) and a second power source (VSS) to control the voltage of the first node (N1); a third driver 14 connected between a first electrode of the eighth transistor (M8) and the first power source (VDD) and controlling the connection of the first power source (VDD) to the first electrode of the eighth transistor (M8) to correspond to the voltage of the first node (N1); and a fourth driver 16 connected between a gate electrode of the eighth transistor (M8) and the second power source (VSS) and controlling the connection of the second power source (VSS) to the gate electrode of the eighth transistor (M8) to correspond to polarities (HIGH or LOW) of the first input signal (IN1), the second input signal (IN2) and the third input signal (IN3).

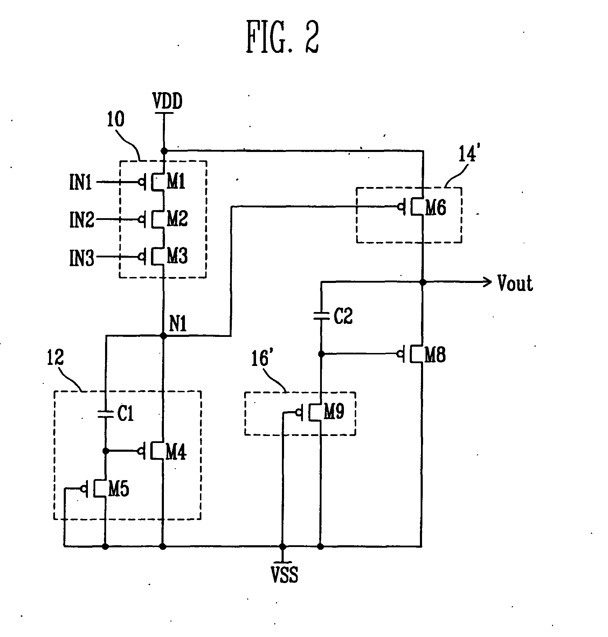

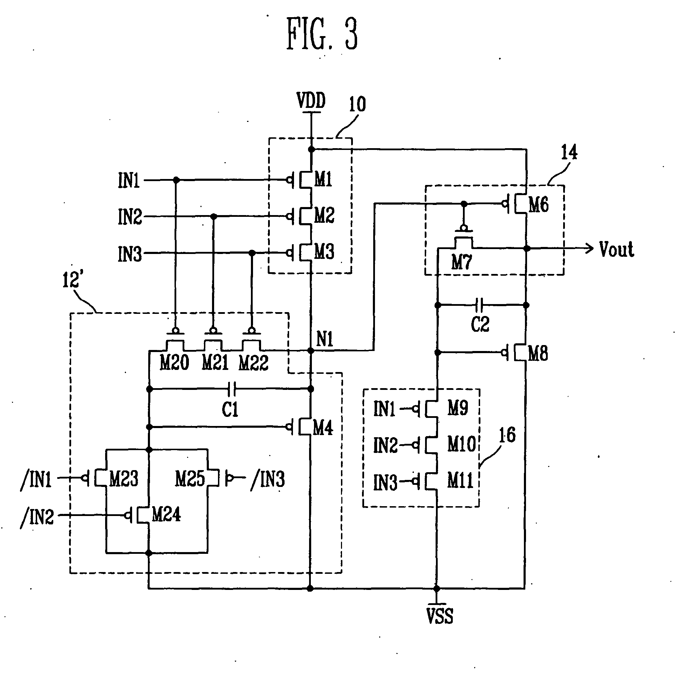

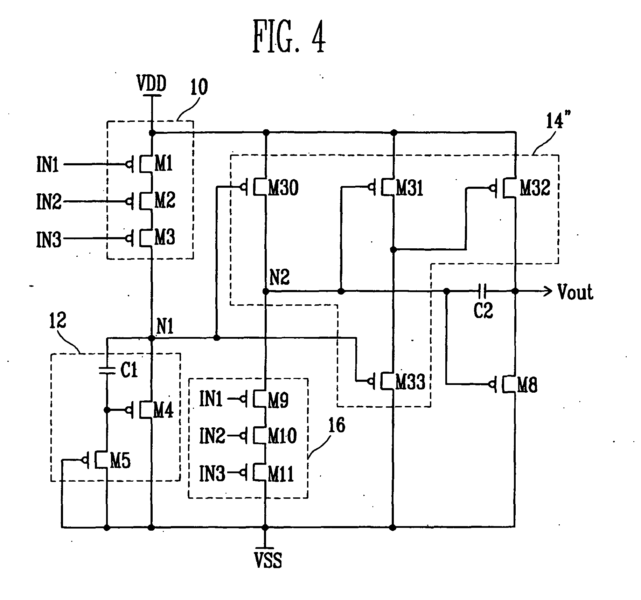

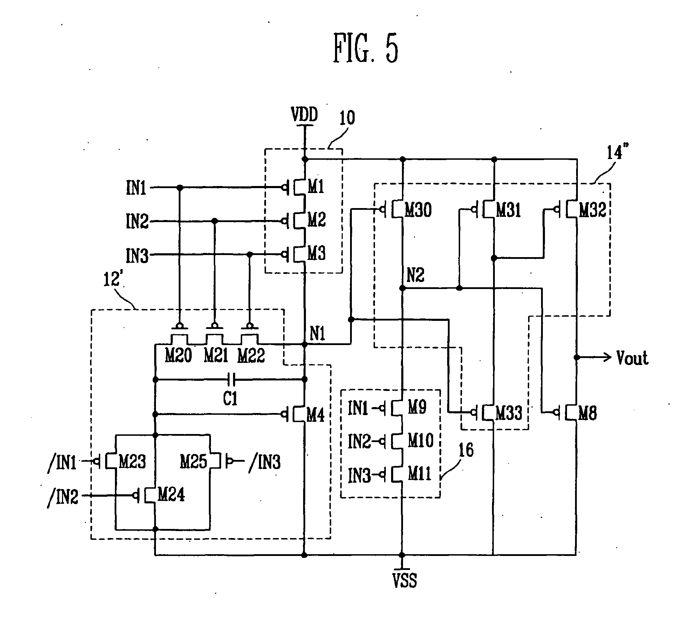

The second driver can be realized in at least one of two different ways, the first one being depicted in FIGS. 1, 2, and 4, the second one in FIGS. 3 and 5. The third driver can be realized in at least three different ways, the first being depicted in FIG. 2, the second in FIGS. 1 and 3, and the third being depicted in FIGS. 4 and 5. The fourth driver can be realized in at least two different way, the first being illustrated in FIG. 2, the second being illustrated in FIGS. 1, 3, 4, and 5. Thus, the present invention discloses no less than twelve different combinations of the second, third, and fourth drivers from which the person skilled in the art may choose according to circumstances of the specific implementation. Only five of the combinations are illustrated by one of the FIGS. 1 through 5, however, the remaining combinations are not to be excluded from the scope of the document.

The eighth transistor (M8) controls the voltage supplied to an output terminal (Vout) while being turned on or turned off by the voltage supplied to its gate electrode. For example, the eighth transistor (M8) is turned off when the voltage of the first power source (VDD) is supplied to its gate electrode, and turned on when the voltage of the second power source (VSS) is supplied to its gate electrode.

The first driver 10 includes a first transistor (M1), a second transistor (M2) and a third transistor (M3), which are connected in series between the first power source (VDD) and the first node (N1). In such a first driver 10, the first power source (VDD) and the first node (N1) are electronically connected to each other when the first input signal (IN1), the second input signal (IN2) and the third input signal (IN3) are set to LOW polarity.

More specifically, the first transistor (M1) is turned on when the first input signal (IN1) has LOW polarity, the second transistor (M2) is turned on when the second input signal (IN2) has LOW polarity and, the third transistor (M3) is turned on when the third input signal (IN3) has LOW polarity. Here, since the first transistor (M1), the second transistor (M2) and the third transistor (M3) are connected in series between the first power source (VDD) and the first node (N1), the first power source (VDD) and the first node (N1) are electronically connected to each other when all of the first input signal (IN1), the second input signal (IN2) and the third input signal (IN3) have LOW polarity.

The second driver 12 includes a fourth transistor (M4) connected between the first node (N1) and the second power source (VSS); a fifth transistor (M5) connected between a gate electrode of the fourth transistor (M4) and a second power source (VSS); and a first capacitor (C1) connected between the gate electrode of the fourth transistor (M4) and a first electrode. The second driver 12 maintains the voltage of the first power source (VDD) when the voltage of the first power source (VDD) is supplied to the first node (N1), and maintains the voltage of the first node (N1) at the voltage of the second power source (VSS) else.

More specifically, a first electrode of the fifth transistor (M5) is connected to the gate electrode of the fourth transistor (M4), and a gate electrode and a second electrode of the fifth transistor (M5) is connected to the second power source (VSS). That is to say, the fifth transistor (M5) is diode-connected to maintain the voltage of the gate electrode of the fourth transistor (M4) roughly at the voltage of the second power source (VSS).

If the first power source (VDD) and the first node (N1) are electronically interrupted by the first driver 10, then the fourth transistor (M4) maintains the voltage of the first node (N1) in LOW polarity (namely, the second power source (VSS)). And, if the first power source (VDD) and the first node (N1) are electronically connected to each other by the first driver 10, then the fourth transistor (M4) maintains the voltage of the first node (N1) in HIGH polarity (namely, the first power source (VDD)). For this purpose, a width/length ratio (W/L) of the fourth transistor (M4) is set to a narrower range than a width/length ratio (W/L) of each of the first transistor (M1), the second transistor (M2) and the third transistor (M3).

Therefore, the voltage of the first power source (VDD) may be stably maintained when the voltage of the first power source (VDD) is supplied to the first node (N1). Meanwhile, a predetermined leakage current may be caused by the fourth transistor (M4) when the voltage of the first power source (VDD) is supplied to the first node (N1). However, if the voltage of the first power source (VDD) is supplied to the first node (N1), then all of the first input signal (IN1), the second input signal (IN2) and the third input signal (IN3) have LOW polarity which happens in the scan driver according to the second aspect of the invention only during extremely short periods. Hence, power consumption is not unduly increased by the leakage current. Furthermore, the first capacitor (C1) charges the voltage between a first electrode and a gate electrode of a fourteenth transistor (M14), thereby to stabilize an operation of the fourth transistor (M14).

The third driver 14 includes a sixth transistor (M6) between the first power source (VDD) and a first electrode of the eighth transistor (M8); and a seventh transistor (M7) connected between a gate electrode and a second electrode of a sixth transistor (M6). The third driver 14 controls the connection of the first electrode of the eighth transistor (M8) to the first power source (VDD) to correspond to the voltage supplied to the first node (N1).

More specifically, the sixth transistor (M6) and the seventh transistor (M7) are turned on when the voltage of LOW polarity is supplied to the first node (N1), and turned off else. If the sixth transistor (M6) is turned on, then the voltage of the first power source (VDD) is supplied to the output terminal (Vout). If the seventh transistor (M7) is turned on, then a first electrode and a gate electrode of the eighth transistor (M8) are electronically connected to each other. That is to say, if the seventh transistor (M7) is turned on, then the voltage of the first power source (VDD) is supplied to the gate electrode of the eighth transistor (M8), and therefore the eighth transistor (M8) is turned off. Here, a second capacitor (C2) connected between the first electrode and the gate electrode of the eighth transistor (M8) charges the voltage between the first electrode and the gate electrode of the eighth transistor (M8), thereby to prevent a leakage current from being generated from the eighth transistor (M8).

The fourth driver 16 includes a ninth transistor (M9), a tenth transistor (M10) and an eleventh transistor (M11) which are all connected in series between the gate electrode of the eighth transistor (M8) and the second power source (VSS). In such a fourth driver 16, the gate electrode of the eighth transistor (M8) and the second power source (VSS) are electronically connected to each other when the first input signal (IN1), the second input signal (IN2) and the third input signal (IN3) are set to LOW polarity.

More specifically, the ninth transistor (M9) is turned on when the first input signal (IN1) has LOW polarity, and the tenth transistor (M10) is turned on when the second input signal (IN2) has LOW polarity. And, the eleventh transistor (M11) is turned on when the third input signal (IN3) has LOW polarity. Here, since the ninth transistor (M9), the tenth transistor (M10) and the eleventh transistor (M11) are connected in series between the gate electrode of the eighth transistor (M8) and the second power source (VSS), the gate electrode of the eighth transistor (M8) and the second power source (VSS) are electronically connected to each other when all of the first input signal (IN1), the second input signal (IN2) and the third input signal (IN3) have LOW polarity.

Table 1 represents a Truth Table of an OR gate according to an embodiment of the invention.

Table 1

| IN1 | IN2 | IN3 | Vout |
|---|---|---|---|
| 0 | 0 | 0 | 0 |
| 0 | 0 | 1 | 1 |
| 0 | 1 | 0 | 1 |
| 0 | 1 | 1 | 1 |
| 1 | 0 | 0 | 1 |
| 1 | 0 | 1 | 1 |
| 1 | 1 | 0 | 1 |
| 1 | 1 | 1 | 1 |

Operation of the OR gate will be described in detail, with reference to FIG. 1 and Table 1. Firstly, any one of a first transistor (M1), a second transistor (M2) and a third transistor (M3) is turned off when any one of a first input signal (IN1), a second input signal (IN2) and a third input signal (IN3) is set to HIGH polarity. Therefore, the first power source (VDD) and the first node (N1) are electronically interrupted, and therefore the voltage of the first node (N1) is roughly set to the voltage of the second power source (VSS).

If the voltage of the first node (N1) is set to LOW polarity, then a sixth transistor (M6) and a seventh transistor (M7) are turned on. If the sixth transistor (M6) and the seventh transistor (M7) are turned on, then the voltage of the first power source (VDD) is output to the output terminal (Vout) (namely, the voltage output of HIGH polarity). And, any one of a ninth transistor (M9), a tenth transistor (M10) and an eleventh transistor (M11) is turned off when any one of the first input signal (IN1), the second input signal (IN2) and the third input signal (IN3) is set to HIGH polarity. Therefore, a gate electrode of the eighth transistor (M8) and the second power source (VSS) are electronically interrupted, and therefore an output voltage of HIGH polarity is maintained stably.

Meanwhile, the first transistor (M1), the second transistor (M2) and the third transistor (M3) are turned on when the first input signal (IN1), the second input signal (IN2) and the third input signal (IN3) are set to LOW polarity. Therefore, the first power source (VDD) and the first node (N1) are electronically connected to each other, and therefore the voltage of the first node (N1) is roughly set to the voltage of the first power source (VDD).

If the voltage of the first node (N1) is set to HIGH polarity, then the sixth transistor (M6) and the seventh transistor (M7) are turned off. And, the ninth transistor (M9), the tenth transistor (M10) and the eleventh transistor (M11) are turned on when the first input signal (IN1), the second input signal (IN2) and the third input signal (IN3) are set to LOW polarity. Therefore, the eighth transistor (M8) is turned on if the voltage of the second power source (VSS) is supplied to a gate electrode of the eighth transistor (M8), and therefore the voltage of LOW polarity is output to the output terminal (Vout).

As described above, the OR gates according to the first embodiment of the present invention are all composed of PMOS transistors. Accordingly, the OR gates may be realized with their being mounted inside a panel of the organic light emitting display, and therefore the manufacturing cost is lowered and the manufacturing process is simple. Of course, it is also possible to realize the OR gates according to the invention using all NMOS transistors by inverting the circuit as is known in the art. Also, it is possible to realize AND gates by connecting the transistors in parallel that are series-connected in the embodiments shown in FIGS. 1 through 5 and vice versa.

Meanwhile, OR gates having three inputs are shown in FIG. 1, but the present invention is not limited thereto. That is to say, the number of the inputs may be controlled by controlling the number of the transistors included in each of the first driver 10 and the fourth driver 16. For example, if four transistors are included in each of the first driver 10 and the fourth driver 16, then OR gates having four inputs may be realized. In the same way it is possible to realize OR gates having two inputs, however, for the use in the scan driver according to the second aspect of the present invention three-inputs logic gates are desirable. Such three-inputs logic gates can also be realized by connecting the output of one two-inputs logic gate to one of the two inputs of another two-inputs logic gate. The remaining input of the second two-inputs logic gate and the two inputs of the first two-inputs logic gate then provide the three inputs of the resulting three-inputs logic gate. Furthermore, for the use in the scan driver according to the second aspect of the invention, logic gates having a higher number of inputs than three can be used. The additional inputs than have to be connected to one of the power supply voltages, in the case of the OR gate realized using PMOS transistors only to the second power supply VSS. The inverted inputs of some of the embodiments disclosed herein would have to be connected to the first power supply VDD.

FIG. 2 is a circuit view showing an OR gate according to the second embodiment of the present invention. In the case of FIG. 2, the same parts as in FIG. 1 are assigned to the same reference numerals, and also their descriptions are omitted herein.

Referring to FIG. 2, the OR gate according to the second embodiment of the present invention comprises a first driver 10, a second driver 12, a third driver (14'), a fourth driver (16') and an eighth transistor (M8) (a control transistor).

The first driver 10 and the second driver 12 are configured and driven in the same manner as shown in FIG. 1. Accordingly, detailed descriptions of the first driver 10 and the second driver 12 are omitted herein.

The third driver (14') includes a sixth transistor (M6) connected between the first power source (VDD) and a first electrode of the eighth transistor (M8). The sixth transistor (M6) controls the connection between the first power source (VDD) and the first electrode of the eighth transistor (M8) to correspond to the voltage applied to the first node (N1).

That is to say, if the voltage of LOW polarity is supplied to the first node (N1), then the sixth transistor (M6) is turned on to electronically connect the first electrode of the eighth transistor (M8 to the first power source (VDD), and the sixth transistor (M6) is turned off to electronically interrupt the first power source (VDD) and the first electrode of the eighth transistor (M8) in the other cases.

The fourth driver (16') includes a ninth transistor (M9) connected between a gate electrode of the eighth transistor (M8) and the second power source (VSS). The first electrode of the ninth transistor (M9) is connected to the gate electrode of the eighth transistor (M8), and a gate electrode and a second electrode of the ninth transistor (M9) are connected to the second power source (VSS). That is to say, the ninth transistor (M9) is diode-connected to maintain the voltage of the gate electrode of the eighth transistor (M8) roughly at the voltage of the second power source (VSS).

The eighth transistor (M8) maintains the voltage of the output terminal (Vout) at LOW polarity (namely, the first power source (VSS)) if the sixth transistor (M6) is turned off. And, the eighth transistor (M8) maintains the voltage of the output terminal (Vout) at HIGH polarity (namely, the first power source (VDD)) if the sixth transistor (M6) is turned on. For this purpose, a width/length ratio (W/L) of the eighth transistor (M8) is set to a narrower range than a width/length ratio (W/L) of the sixth transistor (M6). If the width/length ratio (W/L) of the eighth transistor (M8) is set to a narrower range than the width/length ratio (W/L) of the sixth transistor (M6) as described above, then the voltage of the first power source (VDD) is maintained stably when the voltage of the first power source (VDD) is applied to the output terminal (Vout).

Operation of the OR gate will be described in detail, with reference to FIG. 2 and Table 1. Firstly, any one of a first transistor (M1), a second transistor (M2) and a third transistor (M3) is turned off when any one of a first input signal (IN1), a second input signal (IN2) and a third input signal (IN3) is set to HIGH polarity. Therefore, the first power source (VDD) and the first node (N1) are electronically interrupted, and therefore the voltage of the first node (N1) is roughly set to the voltage of the second power source (VSS).

The sixth transistor (M6) is turned on if the voltage of the first node (N1) is set to LOW polarity. The voltage of the first power source (VDD) is output to the output terminal (Vout) (namely, the voltage output of HIGH polarity) if the sixth transistor (M6) is turned on.

Meanwhile, the first transistor (M1), the second transistor (M2) and the third transistor (M3) are turned on when the first input signal (IN1), the second input signal (IN2) and the third input signal (IN3) are set to LOW polarity. Therefore, the first power source (VDD) and the first node (N1) are electronically connected to each other, and therefore the voltage of the first node (N1) is roughly set to the voltage of the first power source (VDD).

The sixth transistor (M6) is turned off if the voltage of the first node (N1) is set to HIGH polarity, the voltage of the output terminal (Vout) is reduced to the voltage of the second power source (VSS) (namely, the voltage output of LOW polarity) if the sixth transistor (M6) is turned off.

FIG. 3 is a circuit view showing an OR gate according to the third embodiment of the present invention.

In the case of FIG 3, the same parts as in FIG 1 are assigned to the same reference numerals, and also their detailed descriptions are omitted herein.

Referring to FIG. 3, the OR gate according to the third embodiment of the present invention includes a first driver 10, a second driver (12'), a third driver 14, a fourth driver 16 and an eighth transistor (M8).

The first driver 10, the third driver 14, the fourth driver 16 and the eighth transistor (M8) are configured and driven in the same manner as shown in FIG. 1. Accordingly, detailed descriptions of the first driver 10, the third driver 14, the fourth driver 16 and the eighth transistor (M8) are omitted herein.

The second driver (12') includes a fourth transistor (M4) connected between the first node (N1) and the second power source (VSS); a twentieth transistor (M20), a twenty-first transistor (M21) and a twenty-second transistor (M22) connected in series between a first electrode and a gate electrode of the fourth transistor (M4); a first capacitor (C1) connected between the first electrode and the gate electrode of the fourth transistor (M4); and a twenty-third transistor (M23), a twenty-fourth transistor (M24) and a twenty-fifth transistor (M25) connected in parallel between the gate electrode of the fourth transistor (M4) and the second power source (VSS). Such a second driver (12') controls the voltage of the first node (N1) to correspond to input signals (IN1 to IN3) and the inverted input signals (input bar signals /IN1 to /IN3).

More specifically, the twentieth transistor (M20), the twenty-first transistor (M21) and the twenty-second transistor (M22) are connected in series between a first electrode and a gate electrode of the fourth transistor (M4). Here, the twentieth transistor (M20) is controlled by the first input signal (IN1), and the twenty-first transistor (M21) is controlled by the second input signal (IN2). And, the twenty-second transistor (M22) is controlled by the third input signal (IN3). That is to say, the twentieth transistor (M20) to the twenty-second transistor (M22) electronically connect the gate electrode of the fourth transistor (M4) to first node (N1) when the first input signal (IN1) to the third input signal (IN3) are all set to LOW polarity.

The twenty-third transistor (M23) to the twenty-fifth transistor (M25) are connected in parallel between the gate electrode of the fourth transistor (M4) and the second power source (VSS). Here, the twenty-third transistor (M23) is controlled by the first input bar signal (/IN1), and the twenty-fourth transistor (M24) is controlled by the second input bar signal (/IN2). And, the twenty-fifth transistor (M25) is controlled by the third input bar signal (/IN3). That is to say, the twenty-third transistor (M23) to the twenty-fifth transistor (M25) electronically connect the second power source (VSS) to the gate electrode of the fourth transistor (M4) when any one of the first input bar signal (/IN1) to the third input bar signal (/IN3) is set to LOW polarity.

Operation of the OR gate will be described in detail, with reference to FIG. 3 and Table 1. Firstly, any one of a first transistor (M1), a second transistor (M2) and a third transistor (M3) is turned off when any one of a first input signal (IN1), a second input signal (IN2) and a third input signal (IN3) is set to HIGH polarity. And, any one of the twentieth transistor (M20), the twenty-first transistor (M21) and the twenty-second transistor (M22) is turned off when any one of the first input signal (IN1), the second input signal (IN2) and the third input signal (IN3) is set to HIGH polarity.

At this time, any one of the twenty-third transistor (M23), the twenty-fourth transistor (M24) and the twenty-fifth transistor (M25) is turned on if any one of the first input bar signal (/IN1), the second input bar signal (/IN2) and the third input bar signal (/IN3) is set to LOW polarity. Therefore, if the voltage of LOW polarity is supplied to the gate electrode of the fourth transistor (M4), then the fourth transistor (M4) is turned on, and therefore the voltage of LOW polarity is supplied to the first node (N1).

If the voltage of the first node (N1) is set to LOW polarity, then the sixth transistor (M6) and the seventh transistor (M7) are turned on. If the sixth transistor (M6) and the seventh transistor (M7) are turned on, then the voltage of the first power source (VDD) is output to the output terminal (Vout).

Meanwhile, the first transistor (M1), the second transistor (M2) and the third transistor (M3) are turned on when the first input signal (IN1), the second input signal (IN2) and the third input signal (IN3) are set to LOW polarity. And, the twentieth transistor (M20), the twenty-first transistor (M21) and the twenty-second transistor (M22) are turned on when the first input signal (IN1), the second input signal (IN2) and the third input signal (IN3) are set to LOW polarity. Therefore, the voltage of the first node (N1) is set to HIGH polarity since the fourth transistor (M4) is turned off.

Here, the twenty-third transistor (M23) to the twenty-fifth transistor (M25) are turned off since the first input bar signal (/IN1) to the third input bar signal (/IN3) is set to HIGH polarity when the first input signal (IN1), the second input signal (IN2) and the third input signal (IN3) are set to LOW polarity. Accordingly, a turned-off state of the fourth transistor (M4) is maintained stably.

The sixth transistor (M6) and the seventh transistor (M7) are turned off when the voltage of the first node (N1) is set to HIGH polarity. At this time, the voltage of the second power source is supplied to the gate electrode of the eighth transistor (M8) since the ninth transistor (M9) to the eleventh transistor (M11) are turned on, and therefore the eighth transistor (M8) is turned on. If the eighth transistor (M8) is turned on, then the voltage of the second power source (VSS) is supplied to the output terminal (Vout).

FIG. 4 is a circuit view showing an OR gate according to the fourth embodiment of the present invention. In the case of FIG. 4, the same parts as in FIG. 1 are assigned to the same reference numerals, and also their descriptions are omitted herein.

Referring to FIG. 4, the OR gate according to the fourth embodiment of the present invention includes a first driver 10, a second driver 12, a third driver (14"), a fourth driver 16 and an eighth transistor (M8).

The first driver 10, the second driver 12 and the fourth driver 16 are configured and driven in the same manner as shown in FIG. 1. Accordingly, detailed descriptions of the first driver 10, the second driver 12 and the fourth driver 16 are omitted herein.

The third driver (14") controls the voltage supplied to the output terminal (Vout) while controlling whether the eighth transistor (M8) is turned on or turned off corresponding to a voltage value applied to the first node (N1). For this purpose, the third driver (14") includes a thirtieth transistor (M30) connected between a fourth driver 16 and the first power source (VDD); a thirty-first transistor (M31) and a thirty-third transistor (M33) connected between the first power source (VDD) and the second power source (VSS); and a thirty-second transistor (M32) connected between the output terminal (Vout) and the first power source (VDD).

The thirtieth transistor (M30) is arranged between the first power source (VDD) and the fourth driver 16, and then turned on or turned off corresponding to a voltage applied to the first node (N1). Here, the voltage of a second node (N2) is increased to the voltage of the first power source (VDD) if the thirtieth transistor (M30) is turned on.

The thirty-first transistor (M31) controls the voltage value that will be supplied to a gate electrode of the thirty-second transistor (M32) while it is turned on or turned off corresponding to a voltage applied to the second node (N2).

The thirty-third transistor (M33) controls the voltage value that will be supplied to a gate electrode of the thirty-second transistor (M32) while it is turned on or turned off corresponding to a voltage applied to the first node (N1).

The gate electrode of the thirty-second transistor (M32) is connected to a second electrode of the thirty-first transistor (M31) and a first electrode of the thirty-third transistor (M33). Such a thirty-second transistor (M32) controls the connection of the output terminal (Vout) to the first power source (VDD) while it is turned on or turned off corresponding to a voltage supplied to the gate electrode of the thirty-second transistor (M32) itself.

A gate electrode of the eighth transistor (M8) is connected to the second node (N2).The eighth transistor (M8) controls an output voltage of the output terminal (Vout) to correspond to the voltage value supplied to the second node (N2).

Operation of the OR gate will be described in detail, with reference to FIG. 4 and Table 1. Firstly, any one of the first transistor (M1), the second transistor (M2) and the third transistor (M3) is turned off when any one of the first input signal (IN1), the second input signal (IN2) and the third input signal (IN3) is set to HIGH polarity. And, any one of the ninth transistor (M9), the tenth transistor (M10) and the eleventh transistor (M11) is turned off when any one of the first input signal (IN1), the second input signal (IN2) and the third input signal (IN3) is set to HIGH polarity.

If any one of the first transistor (M1), the second transistor (M2) and the third transistor (M3) is turned off, then the voltage of the first node (N1) is set to LOW polarity. If the voltage of the first node (N1) is set to LOW polarity, the thirtieth transistor (M30) and the thirty-third transistor (M33) are turned on. If the thirtieth transistor (M30) is turned on, then the voltage of the second node (N2) is set to the first power source (VDD).

If the voltage of the second node (N2) is set to the first power source (VDD), then the thirty-first transistor (M31) and the eighth transistor (M8) are turned off. In this case, the voltage of the second power source (VSS) is supplied to a gate electrode of the thirty-second transistor (M32) since the thirtythird transistor (M33) is turned on, and therefore the thirty-second transistor (M32) is turned on. Therefore, the voltage of the first power source (VDD) is supplied to the output terminal (Vout) if the thirty-second transistor (M32) is turned on.

Meanwhile, the first transistor (M1), the second transistor (M2) and the third transistor (M3) are turned on when the first input signal (IN1), the second input signal (IN2) and the third input signal (IN3) are set to LOW polarity. The ninth transistor (M9), the tenth transistor (M10) and the eleventh transistor (M11) are turned on when the first input signal (IN1), the second input signal (IN2) and the third input signal (IN3) are set to LOW polarity.

If the first transistor (M1), the second transistor (M2) and the third transistor (M3) are turned on, then the voltage of the first node (N1) is set to HIGH polarity. If the voltage of the first node (N1) is set to HIGH polarity, then the thirtieth transistor (M30) and the thirty-third transistor (M33) are turned off. In this case, the voltage of the second node (N2) is set to the second power source (VSS).

If the voltage of the second node (N2) is set to the second power source (VSS), then the thirty-first transistor (M31) and the eighth transistor (M8) are turned on. If the thirty-first transistor (M31) is turned on, then the voltage of the first power source (VDD) is supplied to a gate electrode of the thirty-second transistor (M32), and therefore the thirty-second transistor (M32) is turned off. In this case, the voltage of the second power source (VSS) is supplied to the output terminal (Vout) since the eighth transistor (M8) is turned on.

FIG. 5 is a circuit view showing an OR gate according to the fifth embodiment of the present invention.

Referring to FIG. 5, the OR gate according to the fifth embodiment of the present invention includes a first driver 10, a second driver (12'), a third driver (14"), a fourth driver 16 and an eighth transistor (M8).

The first driver 10 and the fourth driver 16 are configured in the same manner as in the OR gate as shown in FIG. 1. And, the second driver (12') has the same configuration as in the OR gate as shown in FIG. 3, and the third driver (14") has the same configuration as in the OR gate as shown in FIG.4. Accordingly, detailed description of each of component units (10, 12', 14", 16) is omitted herein.

Operation of the OR gate will be described in detail, with reference to FIG 5 and Table 1. Firstly, any one of the first transistor (M1), the second transistor (M2) and the third transistor (M3) is turned off when any one of the first input signal (IN1), the second input signal (IN2) and the third input signal (IN3) is set to HIGH polarity. And, any one of the twentieth transistor (M20), the twenty-first transistor (M21) and the twenty-second transistor (M22) is turned off when any one of the first input signal (IN1), the second input signal (IN2) and the third input signal (IN3) is set to HIGH polarity.

At this time, if any one of the first input bar signal (/IN1), the second input bar signal (/IN2) and the third input bar signal (/IN3) is set to LOW polarity, then any one of the twenty-third transistor (M23), the twenty-fourth transistor (M24) and the twenty-fifth transistor (M25) is turned on. Therefore, a fourth transistor (M4) is turned on since the voltage of LOW polarity is supplied to a gate electrode of the fourth transistor (M4), and therefore the voltage of LOW polarity is supplied to the first node (N1).

If the voltage of the first node (N1) is set to LOW polarity, then the thirtieth transistor (M30) and the thirty-third transistor (M33) are turned on. If the thirtieth transistor (M30) is turned on, then the voltage of the second node (N2) is set to the first power source (VDD).

If voltage of the second node (N2) is set to the first power source (VDD), then the thirty-first transistor (M31) and the eighth transistor (M8) are turned off. In this case, the voltage of the second power source (VSS) is suppled to a gate electrode of the thirty-second transistor (M32) since the thirty-third transistor (M33) is turned on, and therefore the thirty-second transistor (M32) is turned on. Therefore, the voltage of the first power source (VDD) is supplied to the output terminal (Vout) if the thirty-second transistor (M32) is turned on.

Meanwhile, any one of the first transistor (M1), the second transistor (M2) and the third transistor (M3) are turned on when any one of the first input signal (IN1), the second input signal (IN2) and the third input signal (IN3) are set to LOW polarity. And, any one of the twentieth transistor (M20), the twenty-first transistor (M21) and the twenty-second transistor (M22) are turned on when any one of the first input signal (IN1), the second input signal (IN2) and the third input signal (IN3) is set to LOW polarity. Therefore, the voltage of the first node (N1) is set to HIGH polarity since the fourth transistor (M4) is turned off.

Here, the twenty-third transistor (M23) to the twenty-fifth transistor (M25) are turned off since the first input bar signal (/IN1) to the third input bar signal (/IN3) are set to HIGH polarity when the first input signal (IN1), the second input signal (IN2) and the third input signal (IN3) are set to LOW polarity. Accordingly, a turned-off state of the fourth transistor (M4) is maintained stably.

The thirtieth transistor (M30) and the thirty-third transistor (M33) are turned off if the voltage of the first node (N1) is set to HIGH polarity. In this case, the voltage of the second node (N2) is set to the second power source (VSS). If the voltage of the second node (N2) is set to the second power source (VSS), then the thirty-first transistor (M31) and the eighth transistor (M8) are turned on. If the thirty-first transistor (M31) is turned on, then the voltage of the first power source (VDD) is supplied to a gate electrode of the thirty-second transistor (M32), and therefore the thirty-second transistor (M32) is turned off. In this case, the voltage of the second power source (VSS) is supplied to the output terminal (Vout) since the eighth transistor (M8) is turned on.

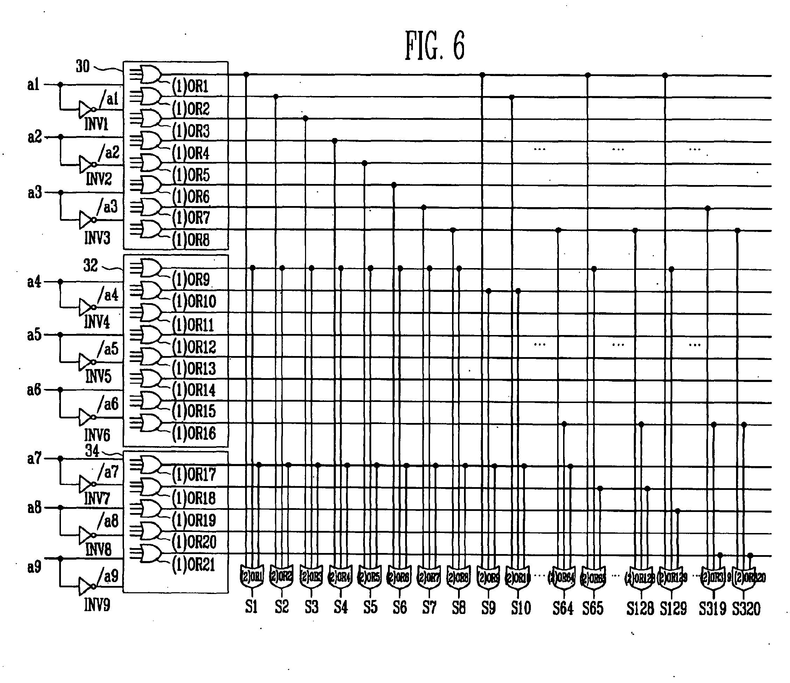

FIG. 6 is a circuit view showing a scan driver realized using the OR gate as shown in any one of FIGs. 1 to 5.

For convenience sake of description, assume that a scan driver is connected to 320 scan lines (S1 to S320) in FIG. 6.

Referring to FIG. 6, the scan driver of the present invention includes a plurality of decoder 30, 32, 34, and a plurality of second OR gates ((2)OR1 to (2)OR320) for performing an OR operation on outputs of the decoders 30, 32, 34 to generate scan signals.

The first decoder 30 and the second decoder 32 includes three input terminals and eight output terminals, and the third decoder 34 includes three input terminals and five output terminals. That is to say, the first decoder 30 and the second decoder 32 includes eight first OR gates ((1)OR1 to (1)OR8, (1)OR9 to (1)OR16), respectively, and the third decoder 34 includes five first OR gates ((1)OR17 to (1)OR21). Here, the number of the first OR gates included in each of the decoders 30, 32, 34 are determined depending on the number of the scan lines (S1 to S320) connected to the scan driver. For example, twentyone first OR gates are formed to supply a scan signal to the 320 scan lines (S1 to S320), as shown in FIG. 6.

The first decoder 30 includes eight first OR gates ((1)OR1 to (1)OR8). Such a first decoder 30 suitably supplies the input signals, supplied from a first input terminal (a1), a second input terminal (a2) and a third input terminal (a3), to the first OR gates ((1)OR1 to (1)OR8). Meanwhile, input bar signals are generated by connecting inverters (INV1, INV2, INV3) to each of the input terminals (a1, a2, s3).

The second decoder 32 includes eight first OR gates ((1)OR9 to (1)OR16). Such a second decoder 32 suitably supplies the input signals, supplied from a fourth input terminal (a4), a fifth input terminal (a5) and a sixth input terminal (a6), to the first OR gates ((1)OR9 to (1)OR16). Meanwhile, input bar signals are generated by connecting inverters (INV4, INV5, INV6) to each of the input terminals (a4, a5, s6).

The third decoder 34 includes five first OR gates ((1)OR17 to (1)OR21). Such a third decoder 34 suitably supplies the input signals, supplied from a seventh input terminal (a7), an eighth input terminal (a8) and a ninth input terminal (a9), to the first OR gates ((1)OR17 to (1)OR21). Meanwhile, input bar signals are generated by connecting inverters (INV7, INV8, INV9) to each of the input terminals (a7, a8, s9).

Each of the second OR gates ((2)OR1 to (2)OR320) receives the output signals from the first decoder 30, the second decoder 32 and the third decoder 34, and is supplied to the scan lines (S1 to S320) by performing an OR operation on the received output signals.

Here, a 1^{st} second OR gate ((2)OR1) supplies a scan signal to the first scan line (S1) by performing an OR operation on outputs of a 1^{st} first OR gate ((1)OR1), a 9^{th} first OR gate ((1)OR9) and a 17^{th} first OR gate ((1)OR17). A 2^{nd} second OR gate ((2)OR2) supplies a scan signal to the second scan line (S2) by performing an OR operation on outputs of a 2^{nd} first OR gate ((1)OR2), a 9^{th} first OR gate ((1)OR9) and a 17^{th} first OR gate ((1)OR17).

And, a 64^{th} second OR gate ((2)OR64) supplies a scan signal to a sixtyfourth scan line (S64) by performing an OR operation on outputs of a 8^{th} first OR gate ((1)OR8), a 16^{th} first OR gate ((1)OR16) and a 17^{th} first OR gate ((1)OR17). A 320^{th} second OR gate ((2)OR320) supplies a scan signal to a threehundredtwentieth scan line (S320) by performing an OR operation on outputs of a 8^{th} first OR gate ((1)OR8), a 16^{th} first OR gate ((1)OR16) and a 21^{st} first OR gate ((1)OR21). That is to say, each of the second OR gates ((2)OR1 to (2)OR320) supply a scan signal to any one of the scan lines (any one of S1 to S320) by performing an OR operation on outputs of the decoders 30, 32, 34 in the present invention.

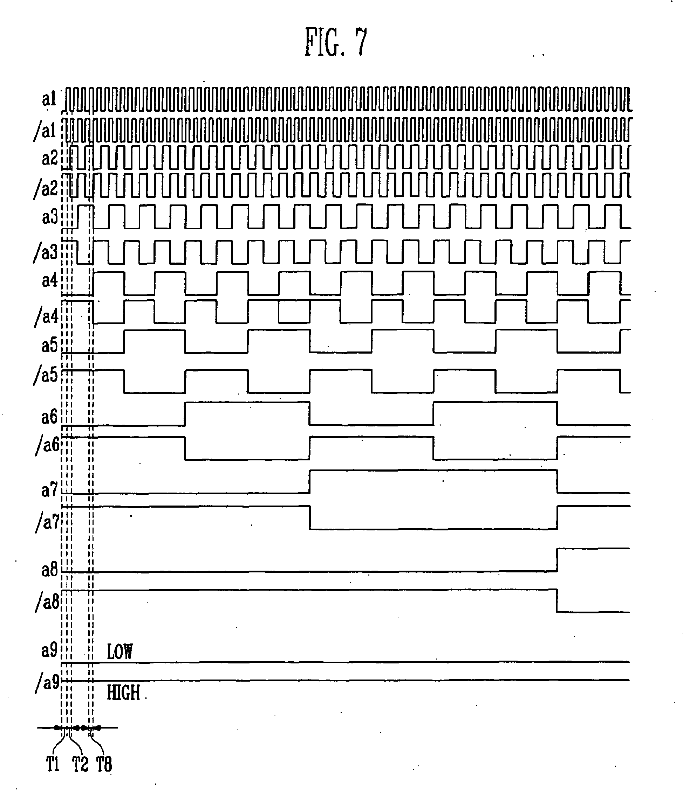

FIG. 7 is a circuit view showing a driving waveform supplied to input terminals as shown in FIG. 6.

Referring to FIG 7, driving waveforms having different frequencies are supplied to the input terminals (a1 to a9). Actually, the frequencies of the driving waveforms are designed to increase twice as the input terminals are transferred from the ninth input terminal (a9) to first input terminal (a1). That is to say, a frequency of the driving waveform supplied to the eighth input terminal (a8) is set to a frequency twice as high as that of the driving waveform supplied to the ninth input terminal (a9), and a frequency of the driving waveform supplied to the seventh input terminal (a7) is set to a frequency twice as high as that of the driving waveform supplied to the eighth input terminal (a8). Also, a frequency of the driving waveform supplied to the sixth input terminal (a6) is set to a frequency twice as high as that of the driving waveform supplied to the seventh input terminal (a7), and a frequency of the driving waveform supplied to the fifth input terminal (a5) ) is set to a frequency twice as high as that of the driving waveform supplied to the sixth input terminal (a6). And, driving waveforms supplied to input bar terminals (/a1 to /a9) are generated by adding an inverter to each of the input terminals (a1 to a9), or received from the outside.

Meanwhile, a parasitic capacitance of a line wire may be minimized in the present invention by arranging the decoders 30, 32, 34 to correspond to the received frequencies. For example, a parasitic capacitance and a resistance may be reduced by arranging the decoder receiving a fast frequency near to the second OR gates ((2)OR1 to (2)OR320), and therefore a response time may be improved.

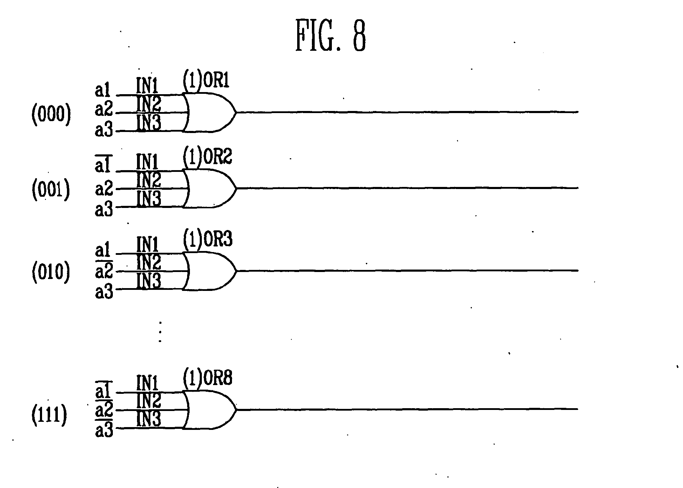

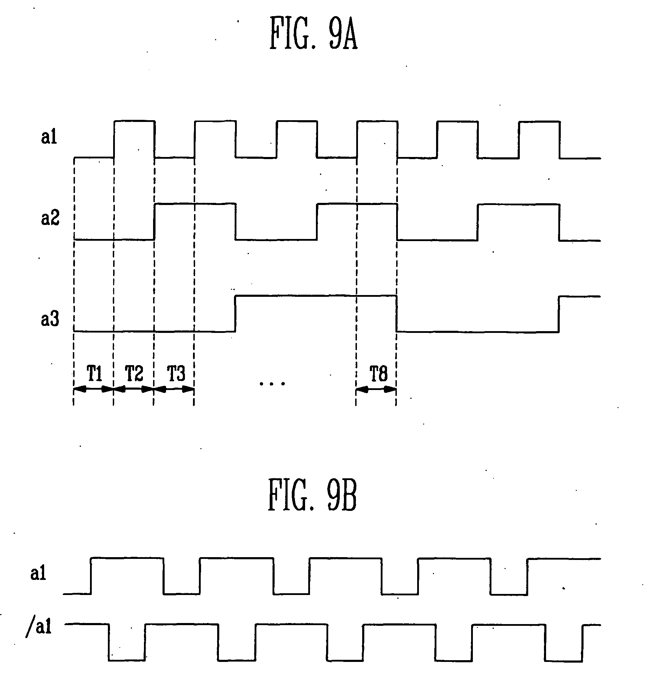

FIG. 8 is a circuit view showing a connection system of the first OR gates as shown in FIG. 6. FIG. 9a is a detailed circuit view showing a driving waveform supplied to the first input terminal (a1), the second input terminal (a2) and the third input terminal (a3) as shown in FIG. 7. For convenience sake of description, a connection configuration of the first OR gates ((1)OR1, (1)OR2), (1)OR3, ..., (1)OR8) included in the first decoder 30 is shown in FIG. 8. Here, a connection configuration of the first OR gates ((1)OR9 to (1)OR21) included in the second decoder and the third decoder 34 is also designed in the same manner as described above except for the input terminals to be connected.

That is to say, a 9^{th} first OR gate ((1)OR9) is connected to the fourth input terminal (a4) to the sixth input terminal (a6) if a 1^{st} first OR gate ((1)OR1) is connected to the first input terminal (a1) to the third input terminal (a3), as shown in FIG. 8. In the same manner, a 17^{th} first OR gate ((1)OR17) is also connected to the seventh input terminal (a7) to the ninth input terminal (a9).

Referring to FIG 8, in order to sequentially output scan signals, the 1^{st} first OR gate ((1)OR1) to the 18^{th} first OR gate ((1)OR8) should sequentially output signals of LOW polarity. For this purpose, the 1^{st} first OR gate ((1)OR1) receives a driving signal of the first input terminal (a1) into the first input signal (IN1), and receives a driving signal of the second input terminal (a2) into the second input signal (IN2). And, the 1^{st} first OR gate ((1)OR1) receives the driving signal, supplied from the third input terminal (a3), into the third input signal (IN3).

Then, a voltage of LOW polarity is output from the 1^{st} first OR gate ((1)OR1) during a first period (T1) as shown in FIG. 9a. Meanwhile, a voltage of LOW polarity is output from the 9^{th} first OR gate ((1)OR9) since the voltage of LOW polarity is supplied to the fourth input terminal (a4), the fifth input terminal (a5) and the sixth input terminal (a6) during the first period (T1). And, a voltage of LOW polarity is output from the 17^{th} first OR gate ((1)OR17) since the voltage of LOW polarity is supplied to the seventh input terminal (a7), the eighth input terminal (a8) and the ninth input terminal (a9) during the first period (T1).

In this case, a voltage of LOW polarity, namely a scan signal is output from the 1^{st} second OR gate ((2)OR1) connected to the 1^{st} first OR gate ((1)OR1), the 9^{th} first OR gate ((1)OR9) and the 17^{tu} first OR gate ((1)OR17). That is to say, the scan signal is output into the first scan line (S1) during the first period (T1).

The 2^{nd} first OR gate ((1)OR2) receives the driving signal, supplied from the first input bar terminal (/a1), into the first input signal (IN1), and receives the driving signal of the second input terminal (a2) into the second input signal (IN2). And, the 2^{nd} first OR gate ((1)OR2) receives the driving signal, supplied from the third input terminal (a3), into the third input signal (IN3).

Then, a voltage of LOW polarity is output from the 2^{nd} first OR gate ((1)OR2) during a second period (T2). Meanwhile, a voltage of LOW polarity is output from the 9^{th} first OR gate ((1)OR9) since the voltage of LOW polarity is supplied to the fourth input terminal (a4), the fifth input terminal (a5) and the sixth input terminal (a6) during the second period (T2). And, a voltage of LOW polarity is output from the 17^{th} first OR gate ((1)OR17) since the voltage of LOW polarity is supplied to the seventh input terminal (a7), the eighth input terminal (a8) and the ninth input terminal (a9) during the second period (T2).

In this case, a voltage of LOW polarity, namely a scan signal is output from the 2^{nd} second OR gate ((2)OR2) connected to the 2^{nd} first OR gate ((1)OR2), the 9^{th} first OR gate ((1)OR9) and the 17^{th} first OR gate ((1)OR17). That is to say, the scan signal is output into the second scan line (S2) during the second period (T2).

The 8^{th} first OR gate ((1)OR8) receives the driving signal, supplied from the first input bar terminal (/a1), into the first input signal (IN1), and receives the driving signal, supplied from the second input bar terminal (/a2), into the second input signal (IN2). And, the 8^{th} first OR gate ((1)OR8) receives the driving signal, supplied from the third input bar terminal (/a3), into the third input signal (IN3).

Then, a voltage of LOW polarity is output from the 8^{th} first OR gate ((1)OR8) during an eighth period (T8). Meanwhile, a voltage of LOW polarity is output from the 9^{th} first OR gate ((1)OR9) since the voltage of LOW polarity is supplied to the fourth input terminal (a4), the fifth input terminal (a5) and the sixth input terminal (a6) during the eighth period (T8). And, a voltage of LOW polarity is output from the 17^{th} first OR gate ((1)OR17) since the voltage of LOW polarity is supplied to the seventh input terminal (a7), the eighth input terminal (a8) and the ninth input terminal (a9) during the eighth period (T8).

In this case, a voltage of LOW polarity, namely a scan signal is output from the 8^{th} second OR gate ((2)OR8) connected to the 8^{th} first OR gate ((1)OR8), the 9^{th} first OR gate ((1)OR9) and the 17^{th} first OR gate ((1)OR17). That is to say, the scan signal is output into the eighth scan line (S8) during eighth period (T8).

In the method as described above, the scan driver of the present invention sequentially supplies a scan signal to the scan lines (S1 to S320). Here, the scan driver of the present invention is composed of OR gates composed of PMOS transistors, and therefore it may be mounted in a panel of the organic light emitting display.

Meanwhile, a connection configuration in which the scan signals are sequentially supplied to the scan lines (S1 to S320) as described above, but the present invention is not limited thereto. In order to compensate for a voltage deviation of pixels in the organic light emitting display, a method for driving an organic light emitting display in a digital mode has been proposed recently. The digital mode is to display a predetermined image by supplying a data signal of "1" or "0" and controlling an emission time of each of the pixels.

If such a digital mode is driven with its being classified into subframe units, there is a problem that a contour noise, etc. may be generated. Accordingly, a method for supplying a scan signal to any of the scan lines instead of sequentially supplying the scan signal has been proposed. For example, a non-emission time is reduced to remove the contour noise using a method in which a scan signal is supplied to the tenth scan line (S10), followed by to the sixtieth scan line (S60). Here, the scan driver of the present invention may simply supply the scan signal to any of the scan lines by changing the driving waveform as shown in FIG. 7 and/or the connection configuration as shown in FIG 6.

For example, the 1^{st} second OR gate ((2)OR1) may be connected to the tenth scan line (S10), and the 2^{nd} second OR gate ((2)OR2) may be connected to the sixtieth scan line (S60). Therefore, the scan signal is supplied to the tenth scan line (S10), followed by to the sixtieth scan line (S60). That is to say, a scan signal may be supplied to a position appointed to supply the scan signal by changing connection positions of the second OR gates ((2)OR1 to (2)OR320) in the present invention, and therefore the scan signal may be easily subject to a digital driving.

Meanwhile, in the present invention, the phases of HIGH polarity may be set to a longer period than the phases of LOW polarity in the driving waveform supplied to the output terminals (a1 to a9, /a1 to /a9), as shown in FIG. 9b.

More specifically, the phases of HIGH polarity may be set to a longer period than the phases of LOW polarity in the driving waveform supplied to the first input terminal (a1). And, the phases of HIGH polarity may be set to a longer period than the phases of LOW polarity in the driving waveform supplied to the first input bar terminal (/a1). In this case, the driving waveform supplied to the first input bar terminal (/a1) is not generated by the inverters but supplied from the outside. As described above, if the phase of HIGH polarity are set to a longer period than the phase of LOW polarity in the driving waveform, then the LOW period may not overlap with the phase of HIGH polarity due to its delay, etc., and therefore a stably driving may be ensured.

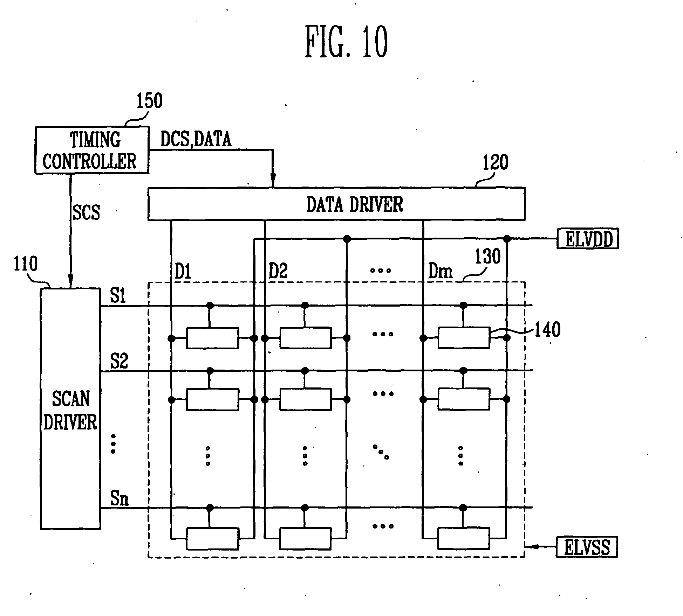

FIG 10 is a schematic view showing an organic light emitting display according to one embodiment of the present invention.

Referring to FIG 10, the organic light emitting display according to the embodiment of the present invention includes a pixel unit 130 including pixels 140 formed in an intersection region of scan lines (S1 to Sn) and data lines (D1 to Dm); a scan driver 110 for driving the scan lines (S1 to Sn); a data driver 120 for driving the data lines (D1 to Dm); and a timing controller 150 for controlling the scan driver 110 and the data driver 120.

The data driver 120 generates data signals in response to a data driving control signal (DCS) supplied from a timing controller 150, and supplies the generated data signals to the data lines (D1 to Dm). At this time, the data driver 120 supplies the data signals, corresponding to one line, to the data lines (D1 to Dm) in every horizontal period (1H).

The scan driver 110 generates scan signals in response to a scan driving control signal (SCS) (for example, a driving waveform as shown in FIG. 7) supplied from the timing controller 150, and supplies the generated scan signals to the scan lines (S 1 to Sn). Here, the scan signals generated in the scan driver 110 are randomly or sequentially supplied to the scan lines (S1 to Sn). And, the scan driver 110 is composed of OR gates composed of PMOS transistor, and then formed in a panel.

Meanwhile, in order to reduce a mounting area of a panel, decoders 30, 32, 34 included in the scan driver 110 may be formed on the data driver 120 in a form of an integrated circuit. That is to say, a data driver 120 is formed to include the decoders 30, 32, 34 when a chip of the data driver 120 is formed. And, a scan driver 110 may be stably driven by electronically connecting the decoders 30, 32, 34 to second OR gates formed in a panel.

The timing controller 150 generates a data driving control signal (DCS) and a scan driving control signal (SCS) to correspond to synchronizing signals supplied from the outside. The data driving control signals (DCS) generated in the timing controller 150 are supplied to the data driver 120, and the scan driving control signals (SCS) is supplied to the scan driver 110. And, the timing controller 150 rearranges datas supplied from the outside, and supplies the datas to the data driver 120.

The pixel unit 130 receives a first driving power source (ELVDD) and a second driving power source (ELVSS) from the outside, and supplies the first driving power source (ELVDD) and the second driving power source (ELVSS) to each of the pixels 140. The pixels 140 receiving the first driving power source (ELVDD) and the second driving power source (ELVSS) correspond to the data signal, thereby to control an electric current capacity flowing from the first driving power source (ELVDD) to the second driving power source (ELVSS) via an organic light emitting diode. For this purpose, each of the pixels 140 includes at least one transistor. Here, the transistors included in each of the pixels 140 are formed along with the transistors included in the scan driver 110 as PMOS transistors.

As described above, the logic gate according to the embodiment of the present invention, and the scan driver and the organic light emitting display using the same may be useful to constitute the scan driver using the OR gates composed of PMOS transistors. In this case, it is possible to mount a scan driver in a panel without increase of the number of masks since all transistors in the scan driver are PMOS transistors. Therefore, the manufacturing cost may be reduced. Also, the scan driver of the present invention may variously set up the order of the scan signals supplied to the scan lines by varying the connection between the driving waveform and/or the OR gates, therefore the scan driver may be easily applicable to various driving processes.

The description proposed herein is just a preferable example for the purpose of illustrations only, not intended to limit the scope of the invention, so it should be understood that other equivalents and modifications could be made thereto without departing from the scope of the invention as apparent to those skilled in the art. Therefore, it should be understood that the present invention might be not defined within the scope of which is described in detailed description but within the scope of which is defined in the claims and their equivalents.

## Claims

1. An OR gate comprising:
a first power source (VDD) adapted to provide a first power supply voltage and a second power source (VSS) adapted to provide a second power supply voltage, different from the first power supply voltage;
a plurality of input terminals (IN1, IN2, IN3) adapted to receive a plurality of input signals;
a first driver (10) having a first terminal connected to the first power source, a second terminal connected to a first node (N1), and a plurality of inputs, each of the plurality of inputs being connected to a corresponding one of the plurality of input terminals;
a second driver (12) having a first terminal connected to the first node, and a second terminal connected to the second power source;
a third driver (14) having a first terminal connected to the first power source, an input connected to the first node, and an output terminal (Vout);
a control transistor (M8) having a first electrode connected to the output terminal of the third driver, a second electrode connected to the second power source, and a gate electrode;
a fourth driver (16) having a first terminal connected to the gate electrode of the control transistor and a second terminal connected to the second power source; and
a first capacitor (C2) having a first terminal connected to the first electrode of the control transistor and a second terminal connected to the gate electrode of the control transistor,
wherein the first driver is adapted to provide the first power supply voltage to the first node corresponding to a logic combination of the plurality of input signals,
wherein the second driver is adapted to provide the second power supply voltage to the first node when the first driver does not provide the first power supply voltage to the first node;
wherein the third driver is adapted to provide the first power supply voltage to the output terminal when the second power supply voltage is provided to the first node; and
wherein the fourth driver is adapted to provide the second power supply voltage to the gate electrode of the control transistor when the third driver does not provide the first power supply voltage to the output terminal,
wherein each of the first driver, the second driver, the third driver and the fourth driver comprises at least one transistor (M1, M2, M3, M4, M5, M6, M7, M9, M10, M11, M20, M21, M22, M23, M24, M25, M30, M31, M32, M33), and the transistors and the control transistor are MOS transistors of the same polarity type.

2. The OR gate of claim 1, wherein the first power supply voltage is higher than the second power supply voltage and wherein the transistors and the control transistors are PMOS transistors.

3. The OR gate according to one of claims 1 or 2, wherein the first driver comprises a first plurality of transistors (M1, M2, M3) connected in series between the first terminal and the second terminal of the first driver and wherein each of the plurality of transistors comprises a gate electrode connected to a corresponding one of the plurality of inputs.

4. The OR gate according to claim 3, wherein the first plurality of transistors comprises:
a first transistor (M1) controlled by a first input signal (IN1) of the plurality of input signals;
a second transistor (M2) controlled by a second input signal (IN2) of the plurality of input signals; and
a third transistor (M3) controlled by a third input signal (IN3) of the plurality of input signals.

5. The OR gate according to one of the preceding claims, wherein the second driver comprises:
a fourth transistor (M4) having a first electrode connected to the first terminal of the second driver and a second electrode connected to the second terminal of the second driver; and a second capacitor (C1) having a first electrode connected to the first electrode of the fourth transistor and a second electrode connected to a gate electrode of the fourth transistor.

6. The OR gate of claim 5, wherein the second driver further comprises a fifth transistor (M5) having a first electrode connected to the gate electrode of the fourth transistor, a second electrode, and a gate electrode, the second electrode and the gate electrode being connected to the second terminal of the second driver.

7. The OR gate according to one of the claims 3 or 4 and to the claims 5 and 6, wherein a width/length ratio of the fourth transistor is set to a narrower range than that of each of the first plurality of transistors.

8. The OR gate according to claim 5, wherein the second driver further comprises:
a second plurality of transistors (M20, M21, M22) connected in series between the first terminal of the second driver and the gate electrode of the fourth transistor, wherein each of the second plurality of transistors comprises a gate electrode connected to a corresponding one of the plurality of input terminals.; and
a third plurality of transistors (M23, M24, M25) connected in parallel between the gate electrode of the fourth transistor and the second terminal of the second driver, wherein each of the third plurality of transistors comprises a gate electrode connected to a corresponding one of a plurality of input bar terminals adapted to receive a plurality of inverted input signals (/IN1, /IN2, /IN3).

9. The OR gate according to one of the preceding claims, wherein the third driver comprises a sixth transistor (M6) having a first electrode connected to the first terminal of the third driver, a second electrode connected to the output terminal of the third driver and a gate electrode connected to the input of the third driver.

10. The OR gate according to claim 9, wherein the third driver further comprises a seventh transistor (M7) having a first electrode connected to the output terminal of the third driver, a second electrode connected to the second terminal of the first capacitor, and a gate electrode connected to the input of the third driver.

11. The OR gate according to one of the claims 1 through 8, wherein the third driver comprises:
a thirtieth transistor (M30) having a first electrode connected to the first terminal of the third driver, a second electrode connected to the gate electrode of the control transistor, and a gate electrode connected to the input of the third driver;
a thirty-first transistor (M31) having a first electrode connected to the first terminal of the third driver and a gate electrode connected to the gate electrode of the control transistors;
a thirty-second transistors (M32) having a first electrode connected to the first terminal of the third driver, a second electrode connected to the output terminal of the third driver, and a gate electrode connected to a second electrode of the thirty-first transistor; and
a thirty-third transistor having a first electrode connected to the second electrode of the thirty-first transistor, a second electrode connected to the second power source, and a gate electrode connected to the input of the third driver.

12. The OR gate according to one of the preceding claims, wherein the fourth driver comprises a ninth transistor (M9) having a first electrode connected to the first terminal of the fourth driver, a second electrode, and a gate electrode.

13. The OR gate according to claim 12, wherein the second electrode of the ninth transistor is connected to the second terminal of the fourth driver and the gate electrode of the ninth transistor is connected to the second terminal of the fourth driver.

14. The OR gate according to claim 13 and one of the claims 9 or 10, wherein a width/length ratio of the control transistor is set to a narrower range than that of the sixth transistor.

15. The OR gate according to the claims 11 and 13, wherein a width/length ratio of the control transistor is set to a narrower range than that of at least one of the thirtieth transistor and the thirty-second transistor.

16. The OR gate according to one of the claims 12 through 15, wherein the fourth driver further comprises:
one or more series-transistors (M10, M11) being series-connected between the second electrode of the ninth transistor and the second terminal of the fourth driver, wherein the gate electrode of the ninth transistor and a gate electrode of each of the one or more series-transistors is connected to a corresponding one of the plurality of input signals.

17. A scan driver comprising:
at least one decoder having a plurality of first OR gates according to one of the preceding claims; and
a plurality of second OR gates according to one of the preceding claims, wherein each of the plurality of input terminals of any of the plurality of second OR gates is connected to an output terminal of one of the plurality of first OR gates of any one of the at least one decoders.

18. The scan driver according to claim 17, wherein the at least one decoder receives at least one signal out of driving signals and driving bar signals, which are set to a longer period of a HIGH polarity than that of a LOW polarity, from the outside.

19. An organic light emitting display comprising a data driver and a display panel, the display panel comprising:
a plurality of data lines extending in a first direction and connected to the data driver;
a plurality of scan lines extending in a second direction;
a plurality of pixels disposed at intersection points of the plurality of data lines and of the plurality of scan lines, each of the plurality of pixels being connected to a corresponding one of the plurality of data lines and a corresponding one of the plurality of scan lines; and
a scan driver according to one of the claims 17 or 18 for supplying scan signals to the plurality of scan lines, wherein the scan driver is integrated into the display panel.

## Patentansprüche

1. ODER-Gatter, umfassend:
eine erste Stromquelle (VDD), die ausgebildet ist, eine erste Versorgungsspannung bereitzustellen, und eine zweite Stromquelle (VSS), die ausgebildet ist, eine sich von der ersten Versorgungsspannung unterscheidende zweite Versorgungsspannung bereitzustellen;
eine Vielzahl von Eingangsanschlüssen (IN1, IN2, IN3), die ausgebildet sind, eine Vielzahl von Eingangssignalen zu empfangen;
einen ersten Treiber (10) mit einem ersten Anschluss, der mit der ersten Stromquelle verbunden ist, einem zweiten Anschluss, der mit einem ersten Knoten (N1) verbunden ist, und einer Vielzahl von Eingängen, wobei jeder der Vielzahl der Eingänge mit einem entsprechenden der Vielzahl von Eingangsanschlüssen verbunden ist;
einen zweiten Treiber (12) mit einem ersten Anschluss, der mit dem ersten Knoten verbunden ist, und einem zweiten Anschluss, der mit der zweiten Stromquelle verbunden ist;
einen dritten Treiber (14) mit einem ersten Anschluss, der mit der ersten Stromquelle verbunden ist, einem Eingang, der mit dem ersten Knoten verbunden ist, und einem Ausgangsanschluss (Vout);
einen Steuertransistor (M8) mit einer ersten Elektrode, die mit dem Ausgangsanschluss des dritten Treibers verbunden ist, einer zweiten Elektrode, die mit der zweiten Stromquelle verbunden ist, und einer Gate-Elektrode;
einen vierten Treiber (16) mit einem ersten Anschluss, der mit der Gate-Elektrode des Steuertransistors verbunden ist, und einem zweiten Anschluss, der mit der zweiten Stromquelle verbunden ist; und
einen ersten Kondensator (C2) mit einem ersten Anschluss, der mit der ersten Elektrode des Steuertransistors verbunden ist, und einem zweiten Anschluss, der mit der Gate-Elektrode des Steuertransistors verbunden ist,
wobei der erste Treiber ausgebildet ist, die erste Versorgungsspannung dem ersten Knoten entsprechend einer logischen Kombination der Vielzahl von Eingangssignalen zur Verfügung zu stellen,
wobei der zweite Treiber ausgebildet ist, die zweite Versorgungsspannung dem
ersten Knoten zur Verfügung zu stellen, wenn der erste Treiber die erste Versorgungsspannung nicht dem ersten Knoten zur Verfügung stellt,
wobei der dritte Treiber ausgebildet ist, die erste Versorgungsspannung dem Ausgangsanschluss zur Verfügung zu stellen, wenn die zweite Versorgungsspannung dem ersten Knoten zur Verfügung gestellt wird; und
wobei der vierte Treiber ausgebildet ist, die zweite Versorgungsspannung der Gate-Elektrode des Steuertransistors zur Verfügung zu stellen, wenn der dritte Treiber die erste Versorgungsspannung nicht dem Ausgangsanschluss zur Verfügung stellt,
wobei der erste Treiber, der zweite Treiber, der dritte Treiber und der vierte Treiber jeweils mindestens einen Transistor (M1, M2, M3, M4, M5, M6, M7, M9, M10, M11, M20, M21, M22, M23, M24, M25, M30, M31, M32, M33) umfassen und die Transistoren sowie der Steuertransistor MOS-Transistoren desselben Polaritätstyps sind.

2. ODER-Gatter nach Anspruch 1, wobei die erste Versorgungsspannung höher ist als die zweite Versorgungsspannung, und wobei die Transistoren sowie die Steuertransistoren PMOS-Transistoren sind.

3. ODER-Gatter nach einem der Ansprüche 1 oder 2, wobei der erste Treiber eine erste Vielzahl von Transistoren (M1, M2, M3) umfasst, die zwischen dem ersten Anschluss und dem zweiten Anschluss des ersten Treibers in Reihe geschaltet sind, und wobei jeder der Vielzahl von Transistoren eine Gate-Elektrode umfasst, die an einen entsprechenden der Vielzahl von Eingängen angeschlossen ist.

4. ODER-Gatter nach Anspruch 3, wobei die erste Vielzahl von Transistoren umfasst:
einen ersten Transistor (M1), der durch ein erstes Eingangssignal (IN1) der Vielzahl von Eingangssignalen gesteuert wird;
einen zweiten Transistor (M2), der durch ein zweites Eingangssignal (IN2) der Vielzahl von Eingangssignalen gesteuert wird; und
einen dritten Transistor (M3), der durch ein drittes Eingangssignal (IN3) der Vielzahl von Eingangssignalen gesteuert wird.

5. ODER-Gatter nach einem der vorstehenden Ansprüche, wobei der zweite Treiber umfasst:
einen vierten Transistor (M4) mit einer ersten Elektrode, die mit dem ersten Anschluss des zweiten Treibers verbunden ist, und einer zweiten Elektrode, die mit
dem zweiten Anschluss des zweiten Treibers verbunden ist; sowie einen zweiten Kondensator (C1) mit einer ersten Elektrode, die mit der ersten Elektrode des vierten Transistors verbunden ist, und einer zweiten Elektrode, die mit einer Gate-Elektrode des vierten Transistors verbunden ist.

6. ODER-Gatter nach Anspruch 5, wobei der zweite Treiber ferner einen fünften Transistor (M5) mit einer ersten Elektrode umfasst, die mit der Gate-Elektrode des vierten Transistors verbunden ist, einer zweiten Elektrode und einer Gate-Elektrode, wobei die zweite Elektrode und die Gate-Elektrode mit dem zweiten Anschluss des zweiten Treibers verbunden sind.

7. ODER-Gatter nach einem der Ansprüche 3 oder 4 und den Ansprüchen 5 und 6, wobei ein Breiten-/Längenverhältnis des vierten Transistors auf einen engeren Bereich gesetzt ist gegenüber demjenigen eines jeden der ersten Vielzahl von Transistoren.

8. ODER-Gatter nach Anspruch 5, wobei der zweite Treiber ferner umfasst:
eine zweite Vielzahl von Transistoren (M20, M21, M22), die zwischen dem ersten Anschluss des zweiten Treibers und der Gate-Elektrode des vierten Transistors in Reihe geschaltet sind, wobei jeder der zweiten Vielzahl von Transistoren eine Gate-Elektrode umfasst, die an einer entsprechenden der Vielzahl von Eingangsanschlüssen angeschlossen ist; und
eine dritte Vielzahl von Transistoren (M23, M24, M25), die zwischen der Gate-Elektrode des vierten Transistors und dem zweiten Anschluss des zweiten Treibers parallel geschaltet sind, wobei jeder der dritten Vielzahl von Transistoren eine Gate-Elektrode umfasst, die an einen entsprechenden einer Vielzahl von Eingangssperranschlüssen angeschlossen ist, die ausgebildet sind, eine Vielzahl von invertierten Eingangssignalen (/IN1, /IN2, /IN3) zu empfangen.

9. ODER-Gatter nach einem der vorstehenden Ansprüche, wobei der dritte Treiber einen sechsten Transistor (M6) mit einer ersten Elektrode umfasst, die mit dem ersten Anschluss des dritten Treibers verbunden ist, einer zweiten Elektrode, die mit dem Ausgangsanschluss des dritten Treibers verbunden ist, und einer Gate-Elektrode, die mit dem Eingang des dritten Treibers verbunden ist.

10. ODER-Gatter nach Anspruch 9, wobei der dritte Treiber ferner einen siebten Transistor (M7) mit einer ersten Elektrode umfasst, die mit dem Ausgangsanschluss des dritten Treibers verbunden ist, einer zweiten Elektrode, die mit dem zweiten Anschluss des ersten Kondensators verbunden ist, und einer Gate-Elektrode, die mit dem Eingang des dritten Treibers verbunden ist.

11. ODER-Gatter nach einem der Ansprüche 1 bis 8, wobei der dritte Treiber umfasst:
einen dreißigsten Transistor (M30) mit einer ersten Elektrode, die mit dem ersten Anschluss des dritten Treibers verbunden ist, einer zweiten Elektrode, die mit der Gate-Elektrode des Steuertransistors verbunden ist, und einer Gate-Elektrode, die mit dem Eingang des dritten Treibers verbunden ist;
einem einunddreißigsten Transistor (M31) mit einer ersten Elektrode, die mit dem ersten Anschluss des dritten Treibers verbunden ist, und einer Gate-Elektrode, die mit der Gate-Elektrode des Steuertransistors verbunden ist;
einen zweiunddreißigsten Transistor (M32) mit einer ersten Elektrode, die mit dem ersten Anschluss des dritten Treibers verbunden ist, einer zweiten Elektrode, die mit dem Ausgangsanschluss des dritten Treibers verbunden ist, und einer Gate-Elektrode, die mit einer zweiten Elektrode des einunddreißigsten Transistors verbunden ist; und
einen dreiunddreißigsten Transistor mit einer ersten Elektrode, die mit der zweiten Elektrode des einunddreißigsten Transistors verbunden ist, einer zweiten Elektrode,
die mit der zweiten Stromquelle verbunden ist, und einer Gate-Elektrode, die mit dem Eingang des dritten Treibers verbunden ist.

12. ODER-Gatter nach einem der vorstehenden Ansprüche, wobei der vierte Treiber einen neunten Transistor (M9) mit einer ersten Elektrode umfasst, die mit dem ersten Anschluss des vierten Treibers verbunden ist, einer zweiten Elektrode und einer Gate-Elektrode.

13. ODER-Gatter nach Anspruch 12, wobei die zweite Elektrode des neunten Transistors mit dem zweiten Anschluss des vierten Treibers verbunden ist, und die Gate-Elektrode des neunten Transistors mit dem zweiten Anschluss des vierten Treibers verbunden ist.

14. ODER-Gatter nach Anspruch 13 und einem der Ansprüche 9 oder 10, wobei ein Breiten-/Längenverhältnis des Steuertransistors auf einen engeren Bereich gesetzt ist gegenüber demjenigen des sechsten Transistors.

15. ODER-Gatter nach den Ansprüchen 11 und 13, wobei ein Breiten-/Längenverhältnis des Steuertransistors auf einen engeren Bereich gesetzt ist gegenüber demjenigen von mindestens einem des dreißigsten Transistors und des zweiunddreißigsten Transistors.

16. ODER-Gatter nach einem der Ansprüche 12 bis 15, wobei der vierte Treiber ferner umfasst:
einen oder mehrere Reihentransistoren (M10, M11), die zwischen der zweiten Elektrode des neunten Transistors und dem zweiten Anschluss des vierten Treibers in Reihe geschaltet sind, wobei die Gate-Elektrode des neunten Transistors und eine Gate-Elektrode jedes des einen oder der mehreren Reihentransistoren mit einem entsprechenden der Vielzahl von Eingangssignalen verbunden ist.

17. Abtasttreiber, umfassend:
mindestens einen Decoder mit einer Vielzahl von ersten ODER-Gattern nach einem der vorstehenden Ansprüche; und
eine Vielzahl von zweiten ODER-Gattern nach einem der vorstehenden Ansprüche,
wobei jeder der Vielzahl von Eingangsanschlüssen irgendeines der Vielzahl von zweiten ODER-Gattern mit einem Ausgangsanschluss eines der Vielzahl von ersten ODER-Gattern irgendeines des mindestens einen Decoders verbunden ist.

18. Abtasttreiber nach Anspruch 17, wobei der mindestens eine Decoder mindestens ein Signal aus Ansteuersignalen und Ansteuersperrsignalen empfängt, die von außerhalb auf einen längeren Zeitraum HOHER Polarität gegenüber demjenigen NIEDERER Polarität gesetzt werden.

19. Organische lichtemittierende Anzeige, umfassend einen Datentreiber und eine Anzeigetafel, wobei die Anzeigetafel umfasst:
eine Vielzahl von Datenleitungen, die sich in eine erste Richtung erstrecken und mit dem Datentreiber verbunden sind;
eine Vielzahl von Abtastzeilen, die sich in eine zweite Richtung erstrecken;
eine Vielzahl von Pixeln, die an Schnittpunkten der Vielzahl von Datenleitungen und
der Vielzahl von Abtastzeilen angeordnet sind, wobei jede der Vielzahl von Pixeln mit einer entsprechenden der Vielzahl von Datenleitungen und einer entsprechenden der Vielzahl von Abtastzeilen verbunden ist; und
einen Abtasttreiber nach einem der Ansprüche 17 oder 18 zum Zuführen von Abtastsignalen an die Vielzahl von Abtastzeilen, wobei der Abtasttreiber in die Anzeigetafel integriert ist.

## Revendications

1. Porte OU, comprenant :
une première source d'alimentation (VDD) adaptée de façon à délivrer une première tension d'alimentation et une deuxième source d'alimentation (VSS) adaptée de façon à délivrer une deuxième tension d'alimentation, différente de la première tension d'alimentation ;
une pluralité de bornes d'entrée (IN1, IN2, IN3) adaptées de façon à recevoir une pluralité de signaux d'entrée ;
un premier dispositif d'attaque (10) comportant une première borne connectée à la première source d'alimentation, une deuxième borne connectée à un premier noeud (N1), et une pluralité d'entrées, chacune de la pluralité d'entrées étant connectée à une borne correspondante de la pluralité de bornes d'entrée ;
un deuxième dispositif d'attaque (12) comportant une première borne connectée au premier noeud, et une deuxième borne connectée à la deuxième source d'alimentation ;
un troisième dispositif d'attaque (14) comportant une première borne connectée à la première source d'alimentation, une entrée connectée au premier noeud, et une borne de sortie (Vout) ;
un transistor de commande (M8) comportant une première électrode connectée à la borne de sortie du troisième dispositif d'attaque, une deuxième électrode connectée à la deuxième source d'alimentation, et une électrode de grille ;
un quatrième dispositif d'attaque (16) comportant une première borne connectée à l'électrode de grille du transistor de commande et une deuxième borne connectée à la deuxième source d'alimentation ; et
un premier condensateur (C2) comportant une première borne connectée à la première électrode du transistor de commande et une deuxième borne connectée à l'électrode de grille du transistor de commande,
dans laquelle le premier dispositif d'attaque est adapté de façon à délivrer la première tension d'alimentation au premier noeud en correspondance avec une combinaison logique de la pluralité de signaux d'entrée ;
dans laquelle le deuxième dispositif d'attaque est adapté de façon à délivrer la deuxième tension d'alimentation au premier noeud lorsque le premier dispositif d'attaque ne délivre pas la première tension d'alimentation au premier noeud ;
dans laquelle le troisième dispositif d'attaque est adapté de façon à délivrer la première tension d'alimentation à la borne de sortie lorsque la deuxième tension d'alimentation est délivrée au premier noeud ; et
dans laquelle le quatrième dispositif d'attaque est adapté de façon à délivrer la deuxième tension d'alimentation à l'électrode de grille du transistor de commande lorsque le troisième dispositif d'attaque ne délivre pas la première tension d'alimentation à la borne de sortie,
dans laquelle chacun du premier dispositif d'attaque, du deuxième dispositif d'attaque, du troisième dispositif d'attaque et du quatrième dispositif d'attaque comprend au moins un transistor (M1, M2, M3, M4, M5, M6, M7, M9, M10, M11, M20, M21, M22, M23, M24, M25, M30, M31, M32, M33), et les transistors et le transistor de commande sont des transistors métal-oxyde-semiconducteur (MOS) du même type de polarité.

2. Porte OU selon la revendication 1, dans laquelle la première tension d'alimentation est supérieure à la deuxième tension d'alimentation, et dans laquelle les transistors et les transistors de commande sont des transistors métal-oxyde-semiconducteur à canal P (PMOS).

3. Porte OU selon l'une des revendications 1 ou 2, dans lequel le premier dispositif d'attaque comprend une première pluralité de transistors (M1, M2, M3) connectés en série entre la première borne et la deuxième borne du premier dispositif d'attaque, et dans laquelle chacun de la pluralité de transistors comprend une électrode de grille connectée à une entrée correspondante de la pluralité d'entrées.

4. Porte OU selon la revendication 3, dans laquelle la première pluralité de transistors comprend :
un premier transistor (M1) commandé par un premier signal d'entrée (IN1) de la pluralité de signaux d'entrée ;
un deuxième transistor (M2) commandé par un deuxième signal d'entrée (IN2) de la pluralité de signaux d'entrée ; et
un troisième transistor (M3) commandé par un troisième signal d'entrée (IN3) de la pluralité de signaux d'entrée.

5. Porte OU selon l'une des revendications précédentes, dans laquelle le deuxième dispositif d'attaque comprend :
un quatrième transistor (M4) comportant une première électrode connectée à la première borne du deuxième dispositif d'attaque et une deuxième électrode connectée à la deuxième borne du deuxième dispositif d'attaque ; et un deuxième condensateur (C1) comportant une première électrode connectée à la première électrode du quatrième transistor et une deuxième électrode connectée à une électrode de grille du quatrième transistor.

6. Porte OU selon la revendication 5, dans laquelle le deuxième dispositif d'attaque comprend de plus un cinquième transistor (M5) comportant une première électrode connectée à l'électrode de grille du quatrième transistor, une deuxième électrode, et une électrode de grille, la deuxième électrode et l'électrode de grille étant connectées à la deuxième borne du deuxième dispositif d'attaque.

7. Porte OU selon l'une des revendications 3 ou 4 et les revendications 5 et 6, dans laquelle un rapport largeur/longueur du quatrième transistor est établi dans une plage plus étroite que celle de chacun de la première pluralité de transistors.

8. Porte OU selon la revendication 5, dans laquelle le deuxième dispositif d'attaque comprend de plus :
une deuxième pluralité de transistors (M20, M21, M22) connectés en série entre la première borne du deuxième dispositif d'attaque et l'électrode de grille du quatrième transistor, chacun de la deuxième pluralité de transistors comprenant une électrode de grille connectée à une borne correspondante de la pluralité de bornes d'entrée ; et
une troisième pluralité de transistors (M23, M24, M25) connectés en parallèle entre l'électrode de grille du quatrième transistor et la deuxième borne du deuxième dispositif d'attaque, chacun de la troisième pluralité de transistors comprenant une électrode de grille connectée à une borne correspondante d'une pluralité de bornes barre d'entrée adaptées de façon à recevoir une pluralité de signaux d'entrée inversés (/IN1, /IN2, /IN3).

9. Porte OU selon l'une des revendications précédentes, dans laquelle le troisième dispositif d'attaque comprend un sixième transistor (M6) comportant une première électrode connectée à la première borne du troisième dispositif d'attaque, une deuxième électrode connectée à la borne de sortie du troisième dispositif d'attaque et une électrode de grille connectée à l'entrée du troisième dispositif d'attaque.

10. Porte OU selon la revendication 9, dans laquelle le troisième dispositif d'attaque comprend de plus un septième transistor (M7) comportant une première électrode connectée à la borne de sortie du troisième dispositif d'attaque, une deuxième électrode connectée à la deuxième borne du premier condensateur, et une électrode de grille connectée à l'entrée du troisième dispositif d'attaque.

11. Porte OU selon l'une des revendications 1 à 8, dans laquelle le troisième dispositif d'attaque comprend :
un trentième transistor (M30) comportant une première électrode connectée à la première borne du troisième dispositif d'attaque, une deuxième électrode connectée à l'électrode de grille du transistor de commande, et une électrode de grille connectée à l'entrée du troisième dispositif d'attaque ;
un trente-et-unième transistor (M31) comportant une première électrode connectée à la première borne du troisième dispositif d'attaque et une électrode de grille connectée à l'électrode de grille des transistors de commande ;
un trente-deuxième transistor (M32) comportant une première électrode connectée à la première borne du troisième dispositif d'attaque, une deuxième électrode connectée à la borne de sortie du troisième dispositif d'attaque, et une électrode de grille connectée à une deuxième électrode du trente-et-unième transistor ; et
un trente-troisième transistor comportant une première électrode connectée à la deuxième électrode du trente-et-unième transistor, une deuxième électrode connectée à la deuxième source d'alimentation, et une électrode de grille connectée à l'entrée du troisième dispositif d'attaque.

12. Porte OU selon l'une des revendications précédentes, dans laquelle le quatrième dispositif d'attaque comprend un neuvième transistor (M9) comportant une première électrode connectée à la première borne du quatrième dispositif d'attaque, une deuxième électrode, et une électrode de grille.

13. Porte OU selon la revendication 12, dans laquelle la deuxième électrode du neuvième transistor est connectée à la deuxième borne du quatrième dispositif d'attaque et l'électrode de grille du neuvième transistor est connectée à la deuxième borne du quatrième dispositif d'attaque.

14. Porte OU selon la revendication 13 et l'une des revendications 9 ou 10, dans laquelle un rapport largeur/longueur du transistor de commande est établi à une plage plus étroite que celle du sixième transistor.

15. Porte OU selon les revendications 11 et 13, dans laquelle un rapport largeur/longueur du transistor de commande est établi à une plage plus étroite que celle d'au moins l'un du trentième transistor et du trente-deuxième transistor.

16. Porte OU selon l'une des revendications 12 à 15, dans laquelle le quatrième dispositif d'attaque comprend de plus :
un ou plusieurs transistors série (M10, M11), qui sont connectés en série entre la deuxième électrode du neuvième transistor et la deuxième borne du quatrième dispositif d'attaque, l'électrode de grille du neuvième transistor et une électrode de grille de chacun des transistors série au nombre d'un ou de plusieurs étant connectées à un signal correspondant de la pluralité de signaux d'entrée.

17. Dispositif d'attaque de balayage, comprenant :
au moins un décodeur comportant une pluralité de premières portes OU selon l'une des revendications précédentes ; et
une pluralité de deuxièmes portes OU selon l'une des revendications précédentes, chacune de la pluralité de bornes d'entrée de l'une quelconque de la pluralité de deuxièmes portes OU étant connectée à une borne de sortie de l'une de la pluralité de premières portes OU de l'un quelconque des décodeurs au nombre d'au moins un.

18. Dispositif d'attaque de balayage selon la revendication 17, dans lequel le décodeur au nombre d'au moins un reçoit au moins un signal parmi des signaux d'attaque et des signaux barre d'attaque, qui sont établis avec une période de polarité HAUTE plus longue que celle de polarité BASSE, à partir de l'extérieur.

19. Dispositif d'affichage à émission de lumière organique, comprenant un dispositif d'attaque de données et un panneau d'affichage, le panneau d'affichage comprenant :
une pluralité de lignes de données s'étendant dans une première direction et connectées au dispositif d'attaque de données ;
une pluralité de lignes de balayage s'étendant dans une deuxième direction ;
une pluralité de pixels disposés à des points d'intersection de la pluralité de lignes de données et de la pluralité de lignes de balayage, chacun de la pluralité de pixels étant connecté à une ligne correspondante de la pluralité de lignes de données et à une ligne correspondante de la pluralité de lignes de balayage ; et
un dispositif d'attaque de balayage selon l'une des revendications 17 ou 18, pour délivrer des signaux de balayage à la pluralité de lignes de balayage, le dispositif d'attaque de balayage étant intégré dans le panneau d'affichage.
